# EUROPÄISCHE PATENTSCHRIFT

(11) **EP 0 807 371 B1**
(45) Veröffentlichungstag und Bekanntmachung des Hinweises auf die Patenterteilung: **26.08.1998**
(21) Anmeldenummer: 96902963.6
(22) Anmeldetag: 01.02.1996
(51) Int. Cl.: H05K 7/18

(54) **SCHALTSCHRANK MIT RAHMENGESTELL UND MONTAGEPLATTE**
SWITCH CABINET WITH RACK AND MOUNTING PLATE
ARMOIRE DE DISTRIBUTION AVEC BAIE ET PLAQUE DE MONTAGE

(30) Priorität: 02.02.1995 DE 19503289
(43) Veröffentlichungstag der Anmeldung: 19.11.1997
(73) Patentinhaber: Rittal-Werk Rudolf Loh GmbH & Co. KG, 35745 Herborn (DE)
(72) Erfinder: BENNER, Rolf, D-35745 Herborn (DE); WINKEL, Roland, D-35745 Herborn (DE)
(74) Vertreter: Fleck, Hermann-Josef, Dr.-Ing.
(86) Internationale Anmeldenummer: EP9600405
(87) Internationale Veröffentlichungsnummer: WO9624236

(56) Entgegenhaltungen:
- AU-A- 5 062 369
- FR-A- 2 116 630
- GB-A- 2 000 017

## Beschreibung

Die Erfindung betrifft einen Schaltschrank mit einem aus Rahmenschenkeln und Eckverbindern zusammengesetzten Rahmengestell, dessen Rahmenschenkel im Bereich der Schrankseiten und der Schrankrückseite mittels Montageschienen miteinander verbunden sind und dessen offene Schrankseiten mittels Wandelementen und mindestens einer Schranktüre verschlossen oder verschließbar sind, und mit mindestens einer im Abstand und parallel zur Schrankrückseite angeordneten und festgelegten Montageplatte, wobei bei einem abgenommenen, als Seitenwand verwendeten Wandelement die Montageplatte mit ihrer unteren und oberen Seite in jeweils eine parallel zur Schrankrückseite ausgerichtete U-förmige Halteschiene einführbar und darin festlegbar ist, wobei die Halteschienen mit ihren offenen Seiten gegeneinander gerichtet und im Abstand an die Höhe der Montageplatte angepaßt sind und wobei die Halteschienen an Rahmenschenkeln des Rahmengestells oder an Montageschienen befestigt sind.

Bei den bekannten Schaltschränken dieser Art wird die Montageplatte außerhalb des Schaltschrankes bestückt und dann in den Schrankkorpus eingesetzt. Ein solcher Schaltschrank ist aus der GB,A,2 000 017 bekannt. Die Montageplate kann, bei abgenommener Seitenwand seitlich in einen Schaltschrank eingeführt werden. Hierzu werden U-förmige Halteschienen verwendet, die mit ihren offenen Seiten gegeneinander gekehrt sind.

Es ist Aufgabe der Erfindung, bei einem Schaltschrank der eingangs erwähnten Art den Einbau der Montageplatte zu erleichtern, auch in den Fällen, in denen sich die Montageplatte nur über einen Teilbereich der Höhe des Rahmengestelles erstreckt.

Diese Aufgabe wird nach der Erfindung durch die Merkmale und Maßnahmen, wie sie im Anspruch 1 oder Anspruch 2 aufgeführt sind, gleich auf einfache und vorteilhafte Weise gelöst.

Demgemäß ist also zum einen vorgesehen, daß die Montageplatte mit ihrer unteren und oberen Seite in jeweils eine parallel zur Schrankrückseite ausgerichtete U-förmige Halteschiene einführbar und darin festlegbar ist, wobei die Halteschienen mit ihren offenen Seiten gegeneinander gerichtet und im Abstand an die Höhe der Montageplatte angepaßt sind und wobei die Halteschienen an Rahmenschenkeln des Rahmengestells oder an Montageschienen befestigt sind. Mit diesen Maßnahmen kann eine Montageplatte, auch wenn auf dieser schwere Bauteile montiert sind, problemlos eingeführt und zu Montagezwecken auch teilweise herausgezogen werden. Ist andererseits, wie in dem unabhängigen Anspruch 2 angegeben, anstelle der oberen U-förmigen Halteschiene die Befestigung der Montageplatte mittels Befestigungsteilen an Rahmenschenkeln des Rahmengestelles oder an Montageschienen vorgesehen, so können Montageplatten beispielsweise auch von vorne eingesetzt werden, wenn seitlich der Innenraum des Schaltschrankes schlecht zugänglich ist, wie z.B. bei einem mittleren meherer aneinander gereihter Schaltschränke. Diese Art, die Montageplatte einzubringen, eignet sich insbesondere auch bei Montageplatten geringeren Höhe, die leichter handhabbar sind und mit ihrer unteren Seite ohne weiteres in die U-förmige Halteschiene eingesetzt und dann hochgeschwenkt werden können. Bei beiden Ausführungen ist vorgesehen, daß die untere U-förmige Halteschiene auf der der Rückwand des Schaltschranks zugekehrten Seite höher ausgebildet ist als auf der von der Rückwand abgekehrten Seite und daß die Montageplatte in ihren Eckbereichen mit Bohrungen für Befestigungsschrauben versehen ist, die in der eingeführten Stellung der Montageplatte mit Schraubaufnahmen im höheren Seitenschenkel der Halteschiene(n) fluchten. Hierduch kann die Montageplatte ohne weitere Befestigungsmittel, wie z.B. Laschen oder dergleichen, schnell und problemlos festgelegt werden, da eine gute Zugänglichkeit geboten ist. Der höhere hintere Seitenschenkel der U-förmigen Halteschiene bietet auch den Vorteil, daß beim Einsetzen der Montageplatte von vorn ein Halt geboten ist, der ein leichtes Einsetzen der unteren Seite der Montageschiene ermöglicht.

Nach einer Ausgestaltung ist vorgesehen, daß die untere und obere Halteschiene an den als Tiefenstreben verwendeten unteren und oberen Rahmenschenkeln angebracht ist oder daß die untere Halteschiene an den als Tiefenstreben verwendeten unteren Rahmenschenkeln angebracht ist, und daß die obere Seite der Montageplatte mittels winkel-, bügel- oder z-förmigen Befestigungsstreben an Rahmenschenkeln des Rahmengestells oder an Montageschienen befestigt ist.

Weitere vorteilhafte Ausgestaltungen sind dadurch gekennzeichnet, daß die untere und obere Halteschiene auf beiden Schrankseiten an einer horizontal ausgerichteten Montageschiene befestigt sind, die jeweils den zugeordneten vorderen und hinteren vertikalen Rahmenschenkel miteinander verbindet oder daß die untere und obere Halteschiene auf beiden Schrankseiten an einer vertikal ausgerichteten Montageschiene befestigt sind, die die jeweils zugeordneten als Tiefenstreben verwendeten unteren und oberen horizontalen Rahmenschenkel miteinander verbindet. Dies richtet sich nach der Größe und dem Ort der Montageplatte im Schaltschrank.

Die obere Seite der Montageplatte kann auch dadurch festgelegt werden, daß die Befestigungsteile mit horizontal oder vertikal ausgerichteten Montageschienen verbunden sind, die in den Schrankseiten oder in der Schrankrückseite angeordnet ist.

Die Montageplatte läßt sich dadurch verstärken und in den Halteschienen besser führen, verschieben und einsetzen, daß die Montageplatte zumindest im Bereich ihrer unteren und oberen Seite einen doppelt abgebogenen Rand aufweist und daß die Halteschienen mit ihren Seitenelementen eine Aufnahme für den Rand der Montageplatte bilden.

Für die Befestigung der Halteschienen ist vorgesehen, daß die Halteschienen an ihren Enden Befestigungslaschen aufweisen, mit denen sie an den zugekehrten Rahmenschenkeln des Rahmengestelles oder den zugekehrten Montageschienen befestigt sind.

Dabei kann die Ausrichtung der Befestigungsplatten so vorgesehen sein, daß die Befestigungslaschen im Bereich des Basisschenkels der Halteschiene seitlich an den Seitenschenkeln abstehen und an einer horizontal ausgerichteten Befestigungsfläche der zugekehrten Rahmenschenkel des Rahmengestells oder der zugekehrten Montageschienen befestigt sind oder daß die Befestigungslaschen am Ende der Seitenschenkel senkrecht nach außen abstehen und mit einer vertikalen Befestigungsfläche der zugekehrten Rahmenschenkel des Rahmengestells oder der zugekehrten Montageschienen verbunden sind.

Das seitliche Einschieben der Montageplatte in die Halteschienen wird dadurch erleichtert, daß die Seitenschenkel der Halteschiene an beiden Enden sich erweiternde Einführungsöffnungen bilden.

Der Einbau von mehreren Montageplatten wird vorteilhafterweise so ausgeführt, daß mehrere Montageplatten übereinander angeordnet sind, wobei mindestens die unteren Seiten aller Montageplatten in eine Halteschiene eingeführt und darin festgelegt sind.

Die Erfindung wird anhand von verschiedenen, mit Zeichnungen dargestellten und anhand dieser abgeleiteten Befestigungsmöglichkeiten für eine Montageplatte näher erläutert. Es zeigen:
- Fig. 1: eine Teilansicht mit der Befestigung einer Halteschiene im Bereich der unteren Tiefenstreben des Rahmengestells, wobei die linke Seitenwand abgenommen ist,
- Fig. 2: eine ähnliche Teilansicht, wobei die Montageplatte im Bereich der abgenommenen rechten Seitenwand eingeführt wird, und
- Fig. 3: eine Teilansicht, die die Befestigung des oberen Bereichs der Montageplatte an von den oberen Teifenstreben beanstandeten Montageschienen zeigt.

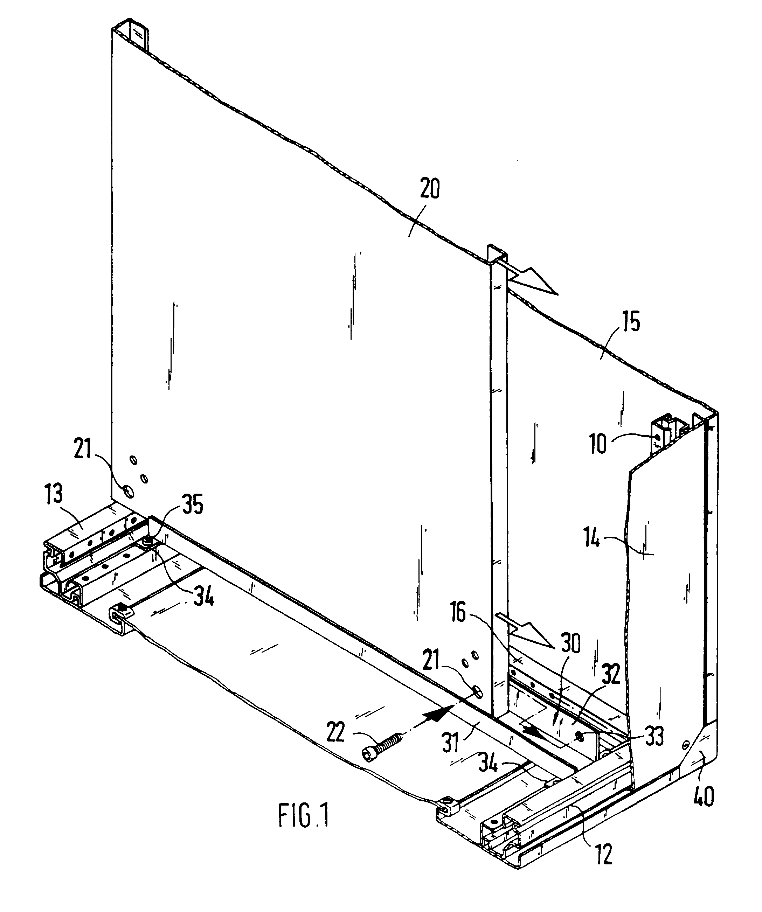

In Fig. 1 ist von dem Schaltschrank und dem Rahmengestell nur der hintere rechte, vertikale Rahmenschenkel 10, die als untere Tiefenstreben 12 und 13 verwendeten Rahmenschenkel der untere hintere horizontale Rahmenschenkel 16, die rechte Seitenwand 14 und die Rückwand 15 zu sehen. Die linke Seitenwand ist abgenommen. Das Rahmengestell ist vollständig und die Vorderseite wird in bekannter Weise mit einer angelenkten Schranktüre verschlossen. Die obere und untere Öffnung des Rahmengestells sind in bekannter Weise mittels Bodenblech und Deckblech verschlossen. Zwischen den als untere Tiefenstreben verwendeten Rahmenschenkeln 12 und 13 ist eine Halteschiene 30 befestigt, die parallel und im Abstand zur Rückwand 15 verläuft. Die Rahmenschenkel 12 und 13 haben eine horizontal ausgerichtete Befestigungsfläche. Die Halteschiene 30 hat Befestigungslaschen 34, die seitlich an den Seitenelementen 31 und 32 der Halteschiene 30 abstehen und mit dem Basisschenkel der Halteschiene 30 in einer Ebene liegen. Mit Befestigungsschrauben 35 wird die Halteschiene 30 an der horizontalen Befestigungsfläche der Rahmenschenkel 12 und 13 festgeschraubt. Von der offenen linken Schrankseite her wird die Montageplatte 20 in die Halteschiene 30 eingeschoben. Hat die Montageplatte 20 ihre Einbaustellung erreicht, dann wird sie mittels Befestigungsschrauben 22 an der Halteschiene 30 festgelegt. Dabei wird die Befestigungsschraube 22 über eine Bohrung 21 der Montageplatte 20 eingeführt und in eine fluchtende Schraubaufnahme 33 eingeschraubt, die in dem der Rückwand 15 zugekehrten Seitenschenkel 32 der Halteschiene 30 eingebracht ist. Der Seitenschenkel 32 ist höher als der der Rückwand 15 abgekehrte Seitenschenkel 31, damit die Schraubverbindung den Seitenschenkel 31 nicht einbezieht. Außerdem kann die Montageplatte 20 von der Schrankvorderseite aus leichter in die Halteschiene 30 eingesetzt werden.

Reicht die Montageplatte 20 bis in den Bereich der oberen Tiefenstreben des Rahmengestells, dann wird auch die obere Seite der Montageplatte 20 in eine Halteschiene 30 geführt. Die obere Halteschiene 30 ist dann in gleicher Weise mit den oberen Tiefenstreben verbunden, mit der offenen Seite jedoch nach unten gerichtet.

Die Montageplatte 20 ist zumindest an der unteren und oberen Seite doppelt rechtwinkelig abgekantet und so verstärkt. Die Seitenschenkel 31 und 32 der Halteschiene 30 bilden eine Aufnahme für den so verstärkten Rand der Montageplatte 20. Die Seitenschenkel 31 und 32 können an den Enden der Halteschiene 30 auch eine sich erweiternde Einführöffnung bilden, die das seitliche Einführen der Montageplatte 20 erleichtert.

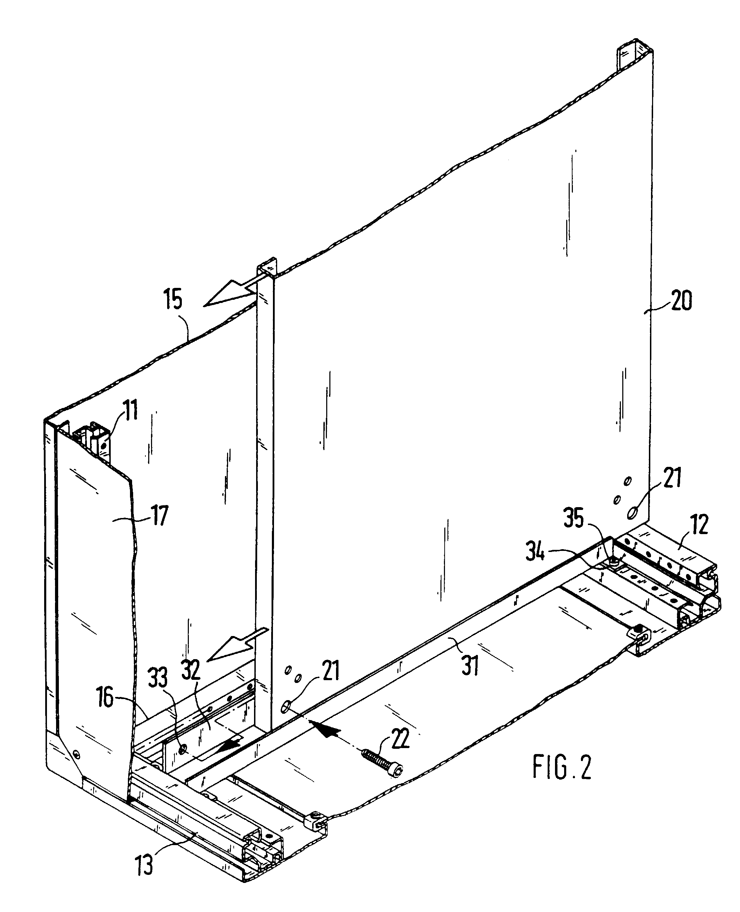

Wie Fig. 2 zeigt, kann die Montageplatte 20 auch bei abgenommener rechter Seitenwand 14 eingeführt werden. Die linke Schrankseite kann durch die Seitenwand 17 verschlossen bleiben, die im Bereich des als Tiefenstrebe verwendeten Rahmenschenkels 13 und des vertikalen, hinteren Rahmenschenkels 11 angebracht ist.

Die Montageplatte 20 wird im Ausführungsbeispiel nach Fig. 2 mittels zweier Befestigungsschrauben 22 festgelegt, die über die Bohrungen 21 der Montageplatte 20 eingeführt und in Schraubaufnahmen 33 im hinteren Seitenschenkel 32 der Halteschiene 30 eingeschraubt werden.

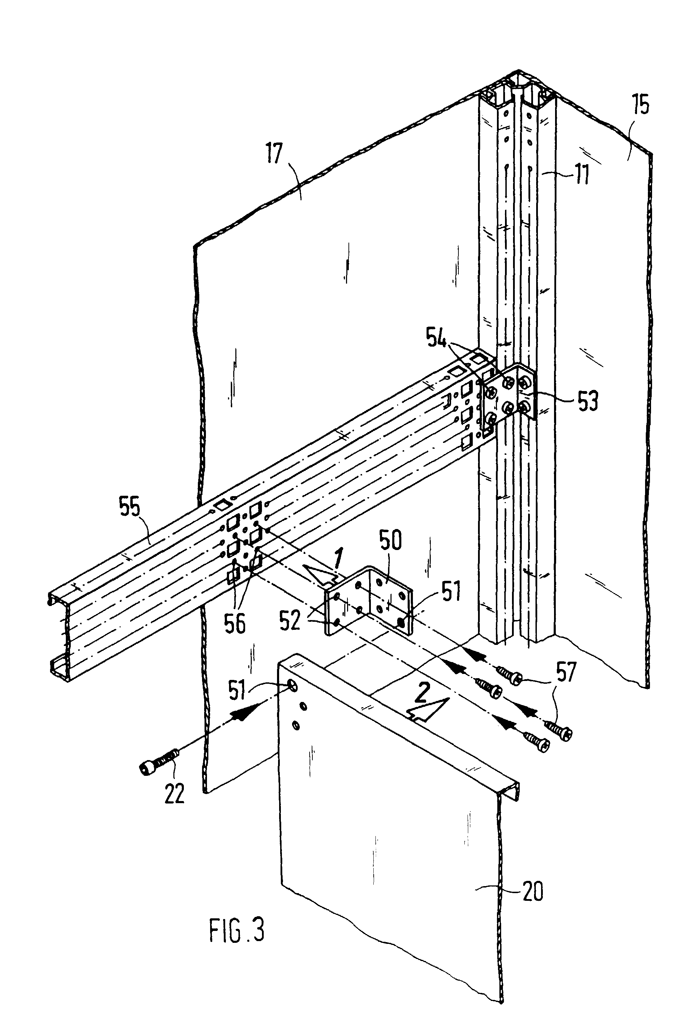

Der obere Bereich der Montageplatte 20 kann auch über Befestigungswinkel 50 an den oberen Tiefenstreben oder an Montageschienen 55 festgelegt werden, die im Abstand parallel zu den oberen Tiefenstreben verlaufen und auf der Schraubseite den vorderen und den hinteren vertikalen Rahmenschenkel 10 verbinden. Die Montageschienen 55 werden über Befestigungswinkel 55 an den vertikalen Rahmenschenkeln, z.B. 11, befestigt, wie Fig. 3 zeigt. Der Abstand von den oberen Tiefenstreben wird so gewählt und auf die Abmessung der Montageplatte 20 abgestimmt, daß das als Winkel ausgebildete Befestigungsteil 50 sowohl die Montageplatte 20 als auch die Montageschiene 55 erfassen kann. Die Befestigungsschrauben 22 werden durch die Bohrungen 21 der Montageplatte 20 eingeführt und in Schraubaufnahmen 51 des Befestigungsteils 50 eingeschraubt. Der andere Schenkel des Befestigungsteils 50 wird mittels Befestigungsschrauben 57 mit Schraubaufnahmen 56 der Montageschiene 55 verbunden. Die in Fig. 3 gezeigte Befestigungsart wiederholt sich an der rechten oberen Ecke der Montageplatte 20. Auf diese Weise kann sich die Montageplatte 20 auch nur über einen Teil der Höhe des Schaltschrankes und Rahmengestells erstrecken. Ist der Abstand zu den hinteren vertikalen Rahmenschenkeln 10 und 11 nicht zu groß, dann kann der obere Bereich der Montageplatte 20 und die Befestigungsteile mit den hinteren vertikalen Rahmenschenkeln 10 und 11 oder mit in der Rückseite des Rahmengestells angebrachten Montageschienen 55 verbunden werden.

Reicht die Montageplatte 20 nicht bis zu den unteren Tiefenstreben 12 und 13, dann können im Abstand zu diesen untere horizontale Montageschienen 50 auf beiden Schraubseiten angebracht werden, die in der Höhe auf die gewünschte Höhe der unteren Seite der Montageplatte 20 abgestimmt sind. In diesen beiden unteren Montageschienen 55 kann dann die untere Halteschiene 30 befestigt werden, wobei die Befestigungslaschen 34 am Ende der Seitenschenkel 31 und 32 parallel zu den Montageschienen 55 ausgerichtet sind. Die Montageschienen 55 können in den Schraubseiten auch vertikal angeordnet sein und jeweils die untere und die oberen Tiefenstreben verbinden.

Die untere Seite der Montageplatte 20 wird stets in einer Halteschiene 30 geführt, während die obere Seite derselben wahlweise in einer oberen Halteschiene geführt und festgelegt ist oder mittels Befestigungsteile an den oberen Tiefenstreben oder an oberen Montageschienen befestigt ist. Die Wahl der Befestigungsart erlaubt auch die Unterbringung von mehreren Montageplatten, die sich über unterschiedliche Teilbereiche der Schrankhöhe erstrecken, wobei die unteren Seiten der Montageplatten stets in einer Halteschiene geführt sind, diese aber an den unteren Tiefenstreben des Rahmengestells oder an unteren, im Abstand zu diesen unteren Tiefenstreben stehenden Montageschienen angebracht sein können. Die untere Halteschiene fängt das Gewicht der bestückten Montageplatte sicher ab.

Die oberen Seiten der Montageplatten können ebenfalls in Halteschienen geführt sein, die wiederum an den oberen Tiefenstreben des Rahmengestells oder an oberen, im Abstand zu diesen oberen Tiefenstreben stehenden Montageschienen angebracht sein können. Die obere Halteschiene für eine Montageplatte kann jedoch auch entfallen, wenn diese Seite der Montageplatte mittels Befestigungsteile an den oberen Tiefenstreben des Rahmengestells, den horizontalen oberen Rahmenschenkeln oder oberen horizontalen oder vertikalen Montageschienen befestigt wird.

## Patentansprüche

1. Schaltschrank mit einem aus Rahmenschenkeln und Eckverbindern zusammengesetzten Rahmengestell, dessen Rahmenschenkel im Bereich der Schrankseiten und der Schrankrückseite mittels Montageschienen miteinander verbunden sind und dessen offene Schrankseiten mittels Wandelementen und mindestens einer Schranktüre verschlossen oder verschließbar sind, und mit mindestens einer im Abstand und parallel zur Schrankrückseite angeordneten und festgelegten Montageplatte, wobei daß bei einem abgenommenen, als Seitenwand verwendeten Wandelement die Montageplatte mit ihrer unteren und oberen Seite in jeweils eine parallel zur Schrankrückseite ausgerichtete U-förmige Halteschiene einführbar und darin festlegbar ist, wobei die Halteschienen mit ihren offenen Seiten gegeneinander gerichtet und im Abstand an die Höhe der Montageplatte angepaßt sind und wobei die Halteschienen an Rahmenschenkeln des Rahmengestells oder an Montageschienen befestigt sind,
dadurch gekennzeichnet,
daß der dem als Rückwand (15) verwendeten Wandelement zugekehrte Seitenschenkel (32) der unteren Halteschiene (30) höher ist als der der Rückwand (15) abgekehrte Seitenschenkel (31) der unteren Halteschiene (30) und
daß die Montageplatte (20) in ihren Eckbereichen mit Bohrungen (21) für Befestigungsschrauben (22) versehen ist, die in der eingeführten Stellung der Montageplatte (20) mit Schraubaufnahmen (33) in den höheren Seitenschenkeln (32) der Halteschienen (30) fluchten.

2. Schaltschrank mit einem aus Rahmenschenkeln und Eckverbindern zusammengesetzten Rahmengestell, dessen Rahmenschenkel im Bereich der Schrankseiten und der Schrankrückseite mittels Montageschienen miteinander verbunden sind und dessen offene Schrankseiten mittels Wandelementen und mindestens einer Schranktüre verschlossen oder verschließbar sind, und mit mindestens einer im Abstand und parallel zur Schrankrückseite angeordneten und festgelegten Montageplatte,
dadurch gekennzeichnet,
daß bei einem abgenommenen, als Seitenwand (14, 17) verwendeten Wandelement oder bei an der Vorderseite angebrachter und geöffneter Schranktüre die untere Seite der Montageplatte (20) in eine parallel zur Schrankrückseite ausgerichtete, U-förmige, nach oben offene untere Halteschiene (30) einschiebbar oder einsetzbar ist, wobei die Halteschiene (30) an Rahmenschenkeln (10, 11, 12, 13, 16) des Rahmengestells oder an Montageschienen (55) befestigt ist,
daß der dem als Rückwand (15) verwendeten Wandelement zugekehrte Seitenschenkel (32) der Halteschiene (30) höher ist als der der Rückwand (15) abgekehrte Seitenschenkel (31) der Halteschiene (30 und
daß die Montageplatte (20) in ihren Eckbereichen mit Bohrungen (21) für Befestigungsschrauben (22) versehen ist, die in der eingeführten Stellung der Montageplatte (20) mit Schraubaufnahmen (33) im höheren Seitenschenkel (32) der Halteschiene (30) fluchten.

3. Schaltschrank nach Anspruch 1,
dadurch gekennzeichnet,
daß die untere und die obere Halteschiene (30) an den als Tiefenstreben verwendeten unteren und oberen Rahmenschenkeln (12, 13) angebracht sind.

4. Schaltschrank nach Anspruch 2,
dadurch gekennzeichnet,
daß die untere Halteschiene (30) an den als Tiefenstreben verwendeten unteren Rahmenschenkeln (12, 13) angebracht ist, und
daß die obere Seite der Montageplatte (20) mittels winkel-, bügel- oder z-förmiger Befestigungsstreben (50) an Rahmenschenkeln (10, 11) des Rahmengestells oder an Montageschienen (55) befestigt ist.

5. Schaltschrank nach einem der Ansprüche 1 oder 3,
dadurch gekennzeichnet,
daß die untere und obere Halteschiene (30) auf beiden Schrankseiten an einer horizontal ausgerichteten Montageschiene (55) befestigt sind, die jeweils den zugeordneten vorderen und hinteren vertikalen Rahmenschenkel (10, 11) miteinander verbindet.

6. Schaltschrank nach einem der Ansprüche 1 oder 3,
dadurch gekennzeichnet,
daß die untere und obere Halteschiene (30) auf beiden Schrankseiten an einer vertikal ausgerichteten Montageschiene (55) befestigt sind, die die jeweils zugeordneten als Tiefenstreben verwendeten unteren und oberen horizontalen Rahmenschenkel (12, 13) miteinander verbindet.

7. Schaltschrank nach einem der Ansprüche 2 oder 4,
dadurch gekennzeichnet,
daß die Befestigungsteile (50) mit horizontal oder vertikal ausgerichteten Montageschienen (55) verbunden sind, die in den Schrankseiten oder in der Schrankrückseite angeordnet sind.

8. Schaltschrank nach einem der Ansprüche 1 bis 7,
dadurch gekennzeichnet,
daß die Montageplatte (20) zumindest im Bereich ihrer unteren und oberen Seite einen doppelt abgebogenen Rand aufweist und
daß die Halteschiene(n) (30) mit ihren Seitenelementen (31, 32) eine Aufnahme für den Rand der Montageplatte (30) bilden.

9. Schaltschrank nach einem der Ansprüche 1 bis 8,
dadurch gekennzeichnet,
daß die Halteschiene(n) (30) an ihren Enden Befestigungslaschen (34) aufweisen, mit denen sie an den zugekehrten Rahmenschenkeln (12, 13) des Rahmengestells oder den zugekehrten Montageschienen (55) befestigt sind.

10. Schaltschrank nach Anspruch 9,
dadurch gekennzeichnet,
daß die Befestigungslaschen (34) im Bereich des Basischenkels der Halteschiene (30) seitlich an den Seitenschenkeln (31, 32) abstehen und an einer horizontal ausgerichteten Befestigungsfläche der zugekehrten Rahmenschenkel (12, 13) des Rahmengestells oder der zugekehrten Montageschiene (55) befestigt sind.

11. Schaltschrank nach Anspruch 9
dadurch gekennzeichnet,
daß die Befestigungslaschen (34) am Ende der Seitenschenkel (31, 32) senkrecht nach außen abstehen und mit einer vertikalen Befestigungsfläche der zugekehrten Rahmenschenkel (12, 13) des Rahmengestells oder der zugekehrten Montageschienen (55) verbunden sind.

12. Schaltschrank nach einem der Ansprüche 1 bis 11,
dadurch gekennzeichnet,
daß die Seitenschenkel (31, 32) der Halteschiene (30) an beiden Enden sich erweiternde Einführungsöffnungen bilden.

13. Schaltschrank nach einem der Ansprüche 1 bis 12,
dadurch gekennzeichnet,
daß mehrere Montageplatten (20) übereinander angeordnet sind, wobei mindestens die unteren Seiten aller Montageplatten (20) in eine Halteschiene (30) eingführt und darin festgelegt sind.

## Claims

1. Switchgear cabinet, including a framework, which comprises frame members and corner joints, the frame members of which framework are interconnected in the region of the cabinet sides and the rear side of the cabinet by means of mounting bars, and the open cabinet sides of which framework are sealed or sealable by means of wall elements and at least one cabinet door, and including at least one mounting plate, which is disposed and secured at a spacing from, and parallel to, the rear side of the cabinet, the mounting plate being insertable, with its lower and upper sides, into a respective U-shaped retaining bar, which is orientated parallel to the rear side of the cabinet, and being securable in said retaining bar, when a wall element is used as a lateral wall and has been removed, the retaining bars being orientated towards one another with their open sides and being adapted to the height of the mounting plate with a spacing therebetween, and the retaining bars being secured to frame members of the framework or to mounting bars, characterised in that the lateral arm (32) of the lower retaining bar (30) facing the wall element used as rear wall (15) is higher than the lateral arm (31) of the lower retaining bar (30) facing away from the rear wall (15), and in that the mounting plate (20) is provided in its corner regions with bores (21) for clamping screws (22), which are in alignment with screw receivers (33) in the higher lateral arms (32) of the retaining bars (30) when the mounting plate (20) is in the inserted position.

2. Switchgear cabinet, including a framework, which comprises frame members and corner joints, the frame members of which framework are interconnected in the region of the cabinet sides and the rear side of the cabinet by means of mounting bars, and the open cabinet sides of which framework are sealed or sealable by means of wall elements and at least one cabinet door, and including at least one mounting plate, which is disposed and secured at a spacing from, and parallel to, the rear side of the cabinet, characterised in that the lower side of the mounting plate (20) can be inserted or slipped into a lower U-shaped retaining bar (30), which is orientated parallel to the rear side of the cabinet and is open towards its upper end, when a wall element is used as lateral wall (14, 17) and has been removed or when a cabinet door has been mounted on the front side and opened, the retaining bar (30) being secured to frame members (10, 11, 12, 13, 16) of the framework or to mounting bars (55), in that the lateral arm (32) of the retaining bar (30) facing the wall element used as rear wall (15) is higher than the lateral arm (31) of the retaining bar (30) facing away from the rear wall (15), and in that the mounting plate (20) is provided in its corner regions with bores (21) for clamping screws (22), which are in alignment with screw receivers (33) in the higher lateral arm (32) of the retaining bar (30) when the mounting plate (20) is in the inserted position.

3. Switchgear cabinet according to claim 1, characterised in that the lower and the upper retaining bars (30) are mounted on the lower and upper frame members (12, 13), which are used as depth bars.

4. Switchgear cabinet according to claim 2, characterised in that the lower retaining bar (30) is mounted on the lower frame members (12, 13), which are used as depth bars, and in that the upper side of the mounting plate (20) is secured to frame members (10, 11) of the framework or to assembly bars (55) by means of angular, arcuate or z-shaped clamping struts (50).

5. Switchgear cabinet according to one of claims 1 or 3, characterised in that the lower and upper retaining bars (30) are secured, on both cabinet sides, to a horizontally orientated mounting bar (55), which interconnects the respective associated front and rear vertical frame members (10, 11).

6. Switchgear cabinet according to one of claims 1 or 3, characterised in that the lower and upper retaining bars (30) are secured, on both cabinet sides, to a vertically orientated mounting bar (55), which interconnects the respective associated lower and upper horizontal frame members (12, 13), which are used as depth bars.

7. Switchgear cabinet according to one of claims 2 or 4, characterised in that the clamping members (50) are connected to horizontally or vertically orientated mounting bars (55), which are disposed in the cabinet sides or in the rear side of the cabinet.

8. Switchgear cabinet according to one of claims 1 to 7, characterised in that the mounting plate (20), at least in the region of its lower and upper sides, has a doubly bent edge, and in that the retaining bar(s) forms (form) with its (their) lateral elements (31, 32), a means for receiving the edge of the mounting plate (30).

9. Switchgear cabinet according to one of claims 1 to 8, characterised in that the retaining bar(s) (30) has (have), at its (their) ends, clamping lugs (34) by means of which said bars are secured to the facing frame members (12, 13) of the framework or to the facing mounting bars (55).

10. Switchgear cabinet according to claim 9, characterised in that the clamping lugs (34) protrude laterally beyond the lateral arms (31, 32) in the region of the base member of the retaining bar (30) and are secured to a horizontally orientated clamping face of the facing frame members (12, 13) of the framework or of the facing mounting bar (55).

11. Switchgear cabinet according to claim 9, characterised in that the clamping lugs (34) protrude vertically outwardly beyond the end of the lateral arms (31, 32) and are connected to a vertical clamping face of the facing frame members (12, 13) of the framework or of the facing mounting bars (55).

12. Switchgear cabinet according to one of claims 1 to 11, characterised in that the lateral arms (31, 32) of the retaining bar (30) form insert apertures which widen at both ends.

13. Switchgear cabinet according to one of claims 1 to 12, characterised in that a plurality of mounting plates (20) are disposed one above the other, at least the lower sides of all of the mounting plates (20) being introduced into a retaining bar (30) and secured therein.

## Revendications

1. Armoire de distribution avec une structure de cadre constituée de branches de cadre et de cornières de jonction, dont les branches de cadre sont, dans la région des côtés et de l'arrière de l'armoire, reliées mutuellement au moyen de rails de montage et dont les côtés d'armoire ouverts sont ou peuvent être fermés au moyen d'éléments de paroi et d'au moins une porte d'armoire, et avec au moins une plaque de montage disposée et assujettie à distance et parallèlement de la face arrière de l'armoire où, lorsque l'élément de paroi servant de paroi latérale est déposé, la plaque de montage peut, par sa face inférieure et supérieure, être introduite par son côté supérieur et par son côté inférieur dans des rails de fixation en forme de U parallèles au dos de l'armoire et peut y être assujettie, les rails de fixation étant par leurs côtés ouverts orientés l'un vers l'autre et étant distants l'un de l'autre de la hauteur de la plaque de montage, et où les rails de fixation sont fixés à des branches de cadre de la structure de cadre ou à des rails de montage,
caractérisée
en ce que la l'aile latérale (32) du rail de fixation inférieur (30), aile qui est orientée vers l'élément de paroi servant de paroi arrière (15), est plus haute que l'aile latérale (31) non orientée vers la paroi arrière (15) du rail de fixation inférieur (30) et
en ce que la plaque de montage (20) présente dans ses régions d'angle des forures (21) pour des vis de fixation (22), qui dans la position de travail de la plaque de montage (20) sont en alignement avec des récepteurs de vis (33) dans les ailes plus hautes (32) des rails de fixation (30).

2. Armoire de distribution avec une structure de cadre constituée de branches de cadre et de cornières de jonction, dont les branches de cadre sont, dans la région des côtés et de l'arrière de l'armoire, reliées mutuellement au moyen de rails de montage et dont les côtés d'armoire ouverts sont ou peuvent être fermés au moyen d'éléments de paroi et d'au moins une porte d'armoire, et avec au moins une plaque de montage disposée et assujettie à distance et parallèlement de la face arrière de l'armoire,
caractérisée
en ce que, lorsqu'un élément de paroi servant de paroi latérale (14, 17) est déposé ou lorsque la porte d'armoire est montée sur la face avant et est ouverte, le côté inférieur de la plaque de montage peut être ou est glissé dans un rail de fixation (30) en forme de U et orienté parallèlement à la face dorsale de l'armoire, ledit rail de fixation étant fixé à des branches de cadre (10, 11, 12, 13, 16) de la structure de cadre ou à des rails de montage,
en ce que l'aile latérale (32) du rail de fixation (30) orientée vers l'élément de paroi servant de paroi arrière (15) est plus haute que l'aile latérale (31) du rail de fixation (30) non orientée vers la paroi arrière (15) et
en ce que dans ses régions d'angle, la plaque de montage (20) présente des forures (21) pour des vis de fixation (22) qui dans la position de travail de la plaque de montage (20) sont en alignement avec des récepteurs de vis (33) dans les ailes plus hautes (32) des rails de fixation (30).

3. Armoire de distribution suivant la revendication 1,
caractérisée
en ce que le rail de fixation inférieur et le rail de fixation supérieur (30) sont montés sur les branches de cadre inférieures et supérieures (12, 13) faisant fonction d'entretoises de profondeur.

4. Armoire de distribution suivant la revendication 2,
caractérisée
en ce que le rail de fixation inférieur (30) est monté sur les branches de cadre inférieures (12, 13) faisant fonction d'entretoises de profondeur, et
en ce que le côté supérieur de la plaque de montage (20) est au moyen d'entretoises de fixation (50) en forme de cornière, d'étrier ou de z, fixé à des branches de cadre (10, 11) de la structure de cadre ou bien à des ails de montage (55).

5. Armoire de distribution suivant l'une ou l'autre des revendications 1 et 3,
caractérisée
en ce que les rails de fixation inférieur et supérieur (30) sont des deux côtés de l'armoire fixés à un rail de montage (55) orienté horizontalement, rail de montage qui connecte les branches de cadre verticales avant et arrière correspondants.

6. Armoire de distribution suivant l'une ou l'autre des revendications 1 et 3,
caractérisée
en ce que les rails de fixation inférieur et supérieur (30) sont des deux côtés de l'armoire fixés à un rail de montage (55) orienté verticalement, rail de montage qui connecte les branches de cadre horizontales inférieure et supérieure correspondants (12) faisant fonction d'entretoises de profondeur.

7. Armoire de distribution suivant l'une ou l'autre des revendications 2 et 4,
caractérisée
en ce que les éléments de fixation (50) sont reliés à des rails de montage (55) orientés horizontalement et verticalement, qui sont disposés dans les côtés latéraux ou dans le dos de l'armoire.

8. Armoire de distribution suivant l'une quelconque des revendications de 1 à 7,
caractérisée
en ce qu'au moins dans la région de son côté inférieur et supérieur, le rail de montage (20) présente un bord à double cintrage et
en ce que le ou les rails de fixation (30) constituent conjointement avec leurs éléments latéraux (31, 32) un moyen de réception pour le bord de la plaque de montage (30).

9. Armoire de distribution suivant l'une quelconque des revendications de 1 à 7,
caractérisée
en ce que le ou les rails de fixation (30) présentent à leurs extrémités libres des pattes de fixation (34) par lesquelles ils sont fixés aux branches de cadre (12, 13) qui leur font face de la structure de cadre ou aux rails de montage (55) qui leur font face.

10. Armoire de distribution suivant la revendication 9,
caractérisée
en ce que dans la région de l'aile de base du rail de fixation (30), les pattes de fixation (34) font protubérance latéralement sur les ailes latérales (31, 32) et sont fixées à une surface de fixation horizontale des branches de cadre (12, 13) de la structure de cadre qui leur font face ou bien du rail de montage (55) qui leur fait face.

11. Armoire de distribution suivant la revendication 9,
caractérisée
en ce qu'à l'extrémité des ailes latérales (31, 32), les pattes de fixation (34) font protubérance verticalement vers l'extérieur et sont reliées à une surface de fixation verticale des branches de cadre (12, 13) de la structure de cadre qui leur font face ou bien des rails de montage (55) qui leur font face.

12. Armoire de distribution suivant l'une quelconque des revendications de 1 à 11,
caractérisée
en ce que les ailes latérales (31, 32) du rail de fixation (30) constituent aux deux extrémités des ouvertures d'introduction évasées.

13. Armoire de distribution suivant l'une quelconque des revendications de 1 à 12,
caractérisée
en ce que plusieurs plaques de montage (20) sont disposées les unes au-dessus des autres, et où au moins les côtés inférieurs de toutes les plaques de montage (20) sont introduits dans un rail de fixation (30) et y sont assujettis.
